# EUROPÄISCHE PATENTSCHRIFT

(11) **EP 1 628 016 B1**
(45) Veröffentlichungstag und Bekanntmachung des Hinweises auf die Patenterteilung: **23.04.2008**
(21) Anmeldenummer: 04104655.8
(22) Anmeldetag: 24.09.2004
(51) Int. Cl.: F02M 51/00, F02M 61/16, H01L 41/053

(54) **Stellantrieb für einen Kraftstoffinjektor einer Brennkraftmaschine**
Actuator for a fuel injector of an internal combustion engine
Actionneur d'un injecteur de carburant d'un moteur à combustion interne

(30) Priorität: 20.08.2004 DE 102004040492
(43) Veröffentlichungstag der Anmeldung: 22.02.2006
(73) Patentinhaber: VDO Automotive AG, 93055 Regensburg (DE)
(72) Erfinder: Plecher, Klaus, 93197 Zeitlarn (DE); Unruh, Marcus, 93197 Zeitlarn (DE)

(56) Entgegenhaltungen:
- DE-A1- 4 410 367
- DE-A1- 10 251 225
- US-A- 5 685 493
- US-A- 6 047 686

## Beschreibung

Die vorliegende Erfindung betrifft einen Stellantrieb für einen Kraftstoffinjektor nach dem Oberbegriff des Anspruchs 1.

Ein derartiger Stellantrieb ist beispielsweise aus der DE 102 51 225 A1 bekannt. Bei diesem Stand der Technik wird zur Schaffung einer dauerhaften, insbesondere öldichten Abdichtung zwischen einem Piezoaktor und einer Außenkontaktierung des Stellantriebs vorgeschlagen, einen kraftstoffbeständigen Dichtring (O-Ring) in jede Öffnung einer aufgesetzten Kopfplatte einzusetzen. In jeder Durchtrittsöffnung ist außerdem unterhalb des Dichtrings eine Hülse aus Isolationsmaterial eingesetzt, die eine Zentrierung und elektrische Isolation des Anschlussstifts bewirkt.

Nachteilig ist bei dieser bekannten Piezoaktorabdichtung, dass diese eine vergleichsweise dicke Kopfplatte erfordert, um in deren Durchtrittsöffnungen jeweils einen Dichtring und eine Zentrierhülse unterzubringen. Außerdem besitzt der in bekannter Weise abgedichtete Stellantrieb eine begrenzte Lebensdauer.

US 5 685 493 A offenbart eine Entlüftung des Magnetspulenraums mittels einer Gasaustauchpassage, die von einer gasdurchlässigen Membrane verschlossen ist.

Es ist daher eine Aufgabe der vorliegenden Erfindung, einen Stellantrieb der eingangs erwähnten Art so weiterzubilden, dass dessen Lebensdauer verlängert wird und eine zuverlässige Abdichtung des Piezoaktors insbesondere auch für vergleichsweise dünne Kopfplatten ermöglicht wird.

Diese Aufgabe wird gelöst mit einem Stellantrieb nach Anspruch 1. Die abhängigen Ansprüche betreffen vorteilhafte Weiterbildungen der Erfindung.

Der erfindungsgemäße Stellantrieb ist dadurch gekennzeichnet, dass wenigstens eine durch ein Stellantriebgehäuse hindurch verlaufende Gasaustauschpassage vorgesehen ist, über welche ein Gasaustausch zwischen der Außenseite und der Innenseite des Stellantriebgehäuses ermöglicht wird, und dass eine auf die Kopfanordnung aufgesetzte und mit Öffnungen zum Durchtritt der Anschlussstifte versehene Abdichteinheit zur Abdichtung des Piezoaktors vorgesehen ist, die einen Träger aufweist, an welchem ein dichtendes Material angeordnet ist, das an Umfangsflächen der Anschlussstifte und an einem Umfangsbereich der Kopfanordnung dichtend anliegt, und an welchem ein aus mikroporösem Material gebildetes Gasaustauschteil zur Schaffung einer Gaspermeabilität der Abdichteinheit derart integriert ist, dass in Einbaulage des Stellantriebs eine etwaig zu dem Gasaustauschteil vorgedrungene Flüssigkeit schwerkraftbedingt vom Gasaustauschteil abfließen kann, insbesondere z. B. wenigstens teilweise sogar über die Gasaustauschpassage aus dem Stellantriebgehäuse wieder herausfließen kann. Letzteres kann in vielfältiger Weise durch Vorsehen wenigstens einer in Einbaulage des Stellantriebs vom Gasaustauschteil "abwärts verlaufenden" Passage realisiert werden (z. B. durch eine erhöhte und/oder geneigte Anordnung der Außenoberfläche des Gasaustauschteils).

Durch die dichtende Anlage sowohl an den Umfangsflächen der Anschlussstifte als auch an der Kopfanordnung wird eine zuverlässige Flüssigkeitsabdichtung ermöglicht. Diese Abdichtung liegt außerhalb des von den Durchtrittsöffnungen der Kopfanordnung begrenzten Bauraums, so dass unabhängig von diesem begrenzten Bauraum der Durchtrittsöffnungen eine erhöhte konstruktive Gestaltungsfreiheit gegeben ist und diese Abdichtung insbesondere auch für vergleichsweise dünne Kopfplatten geeignet ist.

Hinsichtlich der Montage eines Kraftstoffinjektors ermöglicht die Erfindung vorteilhaft die Realisierung der Abdichtung eines mit mehreren Anschlussstiften versehenen Piezoaktors durch Montage einer einzigen Komponente (Abdichteinheit).

Die erhöhte konstruktive Gestaltungsfreiheit, die sich aus der Abdichtung außerhalb des begrenzten Bauraums der Durchtrittsöffnungen ergibt, wird gemäß der Erfindung weiter zur Schaffung einer Gaspermeabilität durch ein an dem Träger integriertes Teil aus mikroporösem Material genutzt (Gasaustauschteil).

Eine bevorzugte Verwendung der erfindungsgemäßen Abdichtungsanordnung ergibt sich für den Piezoaktor eines Kraftstoffinjektors einer Brennkraftmaschine, bei welcher der Kraftstoffinjektor und wenigstens eine weitere Komponente einer Kraftstoffeinspritzeinrichtung im Wesentlichen vollständig innerhalb einer Motorblockbaugruppe der Brennkraftmaschine angeordnet sind. Damit ist insbesondere der Fall gemeint, in welchem Komponenten der Einspritzeinrichtung innerhalb der Motorblockbaugruppe untergebracht sind, die ohne Einschränkung ihrer Funktion auch außerhalb derselben angeordnet werden könnten. Der Begriff "Motorblockbaugruppe" bezeichnet hierbei die Gesamtheit der Motorschmieröl enthaltenden Komponenten, also den "Motorblock" im engeren Sinne und Anbauteile (wie z. B. einen Zylinderkopfdeckel etc.), in denen das Schmieröl gepumpt wird oder schmiert oder (zurück)geführt wird. Bei einer solchen Motorkonstruktion besteht eine erhöhte Gefahr eines Eintrags von "schädlichen Medien" wie Öl und/oder Kraftstoff in den Innenraum eines Injektorgehäuses bzw. einen "Aktorraum". Diese Problematik ergibt sich z. B. insbesondere für Common-Rail-Dieselmotoren mit innerhalb des Zylinderkopfdeckels liegenden Einspritzkomponenten.

Bei internen betrieblichen Versuchen der Anmelderin hat sich überraschenderweise herausgestellt, dass die Anordnung eines piezokeramischen Bauteils wie des hier interessierenden Piezoaktors in einem "möglichst gasdichten" Stellantriebgehäuse in einer schädliche Medien aufweisenden Installationsumgebung die Lebensdauer des Bauteils in der Praxis nicht verlängert sondern tendenziell sogar eher verkürzt. Dasselbe gilt für den Versuch, den Piezoaktor in einem "möglichst gasdichten" Aktorgehäuse (Aktorraum) einzuschließen, welches wiederum innerhalb eines "undichten" Stellantriebgehäuses untergebracht ist.

Demgegenüber kann durch eine gewisse Gasdurchlässigkeit im Bereich der Abdichtungsanordnung eine erhebliche Verlängerung der Haltbarkeit bzw. Lebensdauer des Piezoaktors erzielt werden. Eine mögliche Erklärung besteht darin, dass bei einem möglichst gasdicht abgedichteten Stellantriebgehäuse bzw. Aktorgehäuse unter bestimmten Betriebsbedingungen ein Unterdruck im Gehäuseinnenraum entsteht (z. B. durch Temperaturschwankungen), durch welchen schädliche Medien durch die in der Praxis nicht absolut hermetisch auszubildende Abdichtung hindurch in den Gehäuseinnenraum gelangen können. Andere mögliche Erklärungen bestehen beispielsweise darin, dass sich nach der Fertigung eines hermetisch abgeschlossenen Piezoantriebs die Konzentration irgendeines die Lebensdauer verkürzenden Gases im Innenraum des Piezoantriebs erhöht bzw. das eine der atmosphärischen Luft ähnelnde Füllung des Gehäuseinnenraums eine positive Wirkung auf die Lebensdauer der piezoelektrischen Keramik besitzt.

Durch die gemäß der Erfindung vorgesehene Integration des mikroporösen Materials wird eine gewisse Gasdurchlässigkeit bzw. Druckausgleichsfähigkeit der Abdichtungsanordnung und somit der vorteilhafte Effekt einer Verlängerung der Haltbarkeit bzw. Lebensdauer des Piezoaktors erzielt.

Die Integration des gaspermeablen Teils an dem Träger ist bevorzugt derart vorgesehen, dass sich wenigstens ein Gasaustauschpfad durch die Abdichteinheit hindurch ergibt, in dessen Verlauf zwar das mikroporöse Material liegt, jedoch kein Trägermaterial und kein Dichtmaterial. Damit wird das Gasaustauschvermögen der Abdichtungsanordnung im Wesentlichen unabhängig von dem Trägermaterial und dem Dichtmaterial erzielt. Letztere Materialien können dann für ihre jeweiligen Aufgaben besonders geeignet ausgewählt werden.

Wenngleich es zur Steigerung der Gaspermeabilität der Abdichteinheit durchaus möglich ist, ein dichtendes Material mit hoher Gaspermeabilität (z. B. Silikon- oder Fluorsilikonmaterial) zu wählen, so ist dies z. B. zugunsten einer hinsichtlich der mechanischen und thermischen Eigenschaften optimierten Dichtmaterialauswahl im Allgemeinen nicht erforderlich, da die Gaspermeabilität durch das eigens vorgesehene Gasaustauschteil realisiert wird.

Da der erfindungsgemäße Stellantrieb derart ausgebildet ist, dass eine etwaig zu dem Gasaustauschteil vorgedrungene Flüssigkeit schwerkraftbedingt vom Gasaustauschteil abfließen kann, wird die Funktionsfähigkeit des Gasaustauschteils allenfalls geringfügig durch (nur zeitweise) an der Außenseite des Gasaustauschteils befindliche Flüssigkeit (z. B. Motoröl, kraftstoffverdünntes Motoröl, Wasser) behindert. Bevorzugt bildet die durch das Stellantriebgehäuse hindurch verlaufende Gasaustauschpassage gleichzeitig einen "abwärts verlaufenden" Abflusspfad für etwaig eingedrungene Flüssigkeiten.

Als Material für den Träger kann beispielsweise Kunststoff verwendet werden.

Für das dichtende Material ist die Verwendung eines Elastomers bevorzugt, beispielsweise um eine dauerhaft vorgespannte Dichtanlage an den Anschlussstiften und der Kopfanordnung zu erzielen.

In fertigungstechnisch einfacher Weise lässt sich das dichtende Material z. B. als eine Umspritzung des Trägers ausbilden. Alternativ kann das am Träger angeordnete dichtende Material ganz oder teilweise als eine Komponente in einem Zwei-Komponenten-Spritzgussverfahren bereitgestellt werden.

In einer Ausführungsform ist vorgesehen, dass zwischen dem Träger und dem dichtenden Material eine innige Verbindung durch eine Vulkanisation geschaffen ist.

Insbesondere wenn die Verbindung zwischen dem dichtenden Material und dem Träger an der Abdichteinheit als solcher noch keine besonders gute Abdichtung bereitstellt, also wenn diese Materialien an der Abdichteinheit z. B. lediglich aneinander anliegen, so ist es bevorzugt, wenn - zumindest im installierten Zustand - das dichtende Material zum Träger hin verpresst ist.

Eine derartige Verpressung im montierten Zustand eines Kraftstoffinjektors kann beispielsweise durch Ausübung von Druck durch eine so genannte Kontaktbaugruppe realisiert werden, die zur elektrischen Weiterverbindung der Anschlussstifte zu einer Außenkontaktierung (z. B. Steckverbinder) des Stellantriebs führt. Alternativ oder zusätzlich kann eine solche Verpressung auch durch eine eigens hierfür vorgesehene, mit dem Träger verbundene Komponente der Abdichteinheit bewerkstelligt werden.

Eine Verpressung derjenigen Abschnitte des dichtenden Materials, welche zur Anlage an die Anschlussstifte kommen (Radialabdichtung), sowie derjenigen Abschnitte des Dichtmaterial, die an der Kopfanordnung zur Anlage kommen (Axialabdichtung), besitzt den Vorteil, dass damit die Abdichtwirkung verbessert werden kann.

In einer bevorzugten Ausführungsform ist vorgesehen, dass das dichtende Material im Bereich der Radialabdichtung mit elastischer Vorspannung an den Umfangsflächen der betreffenden Anschlussstiftabschnitte anliegt. Dies lässt sich in einfacher Weise dadurch realisieren, dass ein elastisches Dichtmaterial mit Öffnungen zum Durchtritt der Anschlussstifte gebildet ist und jede Öffnungsquerschnittsfläche im entspannten Zustand des Dichtmaterials kleiner als die Querschnittsfläche des Anschlussstiftabschnitts im Bereich der Radialabdichtung ist.

Eine kompakte Gestaltung der Abdichteinheit ergibt sich beispielsweise dann, wenn sowohl die Radialabdichtung als auch die Axialabdichtung an entsprechenden Bereichen eines insgesamt im Wesentlichen scheibenartig ausgebildeten Abdichteinheitskorpus vorgesehen ist. Aus der Scheibenebene heraus können sich zur Erzielung einer besonders zuverlässigen Radialabdichtung auch Abschnitte des Trägers und/oder des Dichtmaterials in axialer Richtung an den Anschlussstiften entlang (diese umschließend) erstrecken. Mit dieser Gestaltung lässt sich eine vergrößerte Radialabdichtungsfläche und/oder eine vergrößerte, durch elastische Vorspannung des Dichtmaterials bewirkte Radialabdichtungskraft erzielen. Ferner kann sich aus der Scheibenebene heraus ein axial abstehender Trägerabschnitt erstrecken, an welchem das mikroporöse Gasaustauschteil auf "erhöhtem Niveau" angeordnet ist, z. B. in einem oberen Endbereich eines solchen emporragenden Trägerabschnitts. Alternativ oder zusätzlich kann eine (gegenüber der Horizontalrichtung) geneigte oder konvex gekrümmte Außenoberfläche des Gasaustauschteils vorgesehen sein.

In einer besonders kompakten Ausführungsform ist vorgesehen, dass die der Kopfanordnung zugewandte Stirnseite der Abdichteinheit im Wesentlichen der Kontur der Kopfanordnung folgt. Bevorzugt liegt das Dichtmaterial wenigstens ringförmig am Umfang der Kopfanordnung umlaufend dichtend an, um die Axialabdichtung zu gewährleisten. Das Dichtmaterial kann hierbei z. B. einteilig scheibenartig ausgebildet sein, wobei der Scheibenkorpus eine zentrale Öffnung für die Schaffung einer zum Gasaustauschteil führenden Gasaustauschpassage sowie zwei weitere, exzentrische Öffnungen zum Durchtritt bzw. zur Radialabdichtung der Anschlussstifte aufweist.

In an sich bekannter Weise kann die Kopfanordnung eine Kopfplatte umfassen, in welcher die Öffnungen der Kopfanordnung zum Durchtritt der Anschlussstifte vorgesehen sind.

In einer bevorzugten Ausführungsform ist der Piezoaktor in einem Aktorraum untergebracht, der von einem hülsenartigen Aktorgehäuse sowie einer Kopfplatte und einer Bodenplatte gebildet ist, die zu beiden Enden dieses Aktorgehäuses angeordnet sind. Die Kopfplatte kann hierbei an einem axialen Ende des Aktorgehäuses eingesetzt und mit diesem verschweißt sein, wohingegen in diesem Fall die Bodenplatte axial verschiebbar im Aktorgehäuse geführt ist. Innerhalb eines solchen Aktorraums kann der Piezoaktor unter axialer Druckvorspannung in einer axial langgestreckten Rohrfeder gehalten sein, die zu ihren beiden Enden mit der Kopfplatte und der Bodenplatte verschweißt ist. Die Bodenplatte kann als Teil einer zu einem Betätigungsglied eines Kraftstoffeinspritzventils hin wirkenden Wirkverbindung ausgebildet sein. In diesem Bereich kann die Abdichtung des Aktorraums in an sich bekannter Weise durch eine zwischen der Innenwandung des Aktorgehäuses und der Bodenplatte eingeschweißten Membran erfolgen.

Um eine zuverlässige Axialabdichtung sicherzustellen, kann das dichtende Material beispielsweise wenigstens in einem ringförmig die Anschlussstifte umgebenden Bereich axial zur Kopfanordnung hin verpresst sein, z. B. gegen das axiale Ende des oben erwähnten Aktorgehäuses.

Eine solche Verpressung im Bereich der Axialabdichtung kann beispielsweise durch Ausübung axialen Drucks von einer an einem oberen Ende eines Injektorgehäuses angeordneten Kontaktbaugruppe zum elektrischen Anschluss des Injektors vorgesehen sein. In einer Ausführungsform ist vorgesehen, dass eine solche Kontaktbaugruppe das dichtende Material wenigstens abschnittsweise gegen die Kopfanordnung presst. Diese somit gewissermaßen zwischen der Kontaktbaugruppe und der Kopfanordnung eingeklemmten Dichtmaterialabschnitte können dann die Axialabdichtung vorsehen.

Die Axialabdichtung kann in einfacher Weise bewerkstelligt werden durch ein Einklemmen eines ringförmig geschlossenen Dichtmaterialbereiches zwischen der Kontaktbaugruppe und der Kopfanordnung. Das Anpressen des Dichtmaterials gegen die Kopfanordnung erfolgt in gut definierter Weise, wenn die Kontaktbaugruppe hierfür mit einem oder mehreren der Abdichteinheit zugewandten Vorsprüngen versehen ist, die bei der Montage des Kraftstoffinjektors zu der gewünschten Verpressung der entsprechenden Dichtmaterialabschnitte führen.

Eine einfache Montage der Kontaktbaugruppe, bei welcher die oben erläuterte Verpressung des Dichtmaterials gewährleistet werden kann, ergibt sich, wenn die Kontaktbaugruppe einen Umfangsbereich der Kopfanordnung umgreift und an diesem Umfangsbereich durch eine Formschlussverbindung gehalten ist. Diese Formschlussverbindung kann insbesondere als Rastverbindung derart vorgesehen sein, dass durch das Aufdrücken der Kontaktbaugruppe deren Verrastung mit der Kopfanordnung erfolgt. Die Rastverbindung kann z. B. ringförmig am Umfang verlaufend oder auch durch eine Mehrzahl von über den Umfang verteilten, separaten Rastbereichen vorgesehen sein. Eine besonders dauerhafte und dichte Axialabdichtung ergibt sich, wenn die Rastverbindung nachträglich in einer finalen Kunststoffumspritzung fixiert wird. Die Schrumpfung des Kunststoffmaterials erhöht die Anpresskraft und damit die auf das Dichtmaterial wirkende Klemmkraft.

In einer Ausführungsform ist vorgesehen, dass eine mit Öffnungen zum Durchtritt der Anschlussstifte versehene Isolierscheibe aus elektrisch isolierendem Material zwischen der Abdichteinheit und der Kopfanordnung angeordnet ist. Damit können die Anforderungen an die elektrische Isolationsfähigkeit der Abdichteinheitskomponenten (insbesondere Dichtmaterial) verringert werden. Außerdem kann das "effektive Aktorraumvolumen" durch das Vorhandensein einer solchen Isolierscheibe vergrößert werden, indem mehr oder weniger große Spalte zwischen einer solchen Isolierscheibe und angrenzenden Bauteilen, wie z. B. einer Kopfplatte und der Abdichteinheit, vorgesehen werden. Solche Spalte ergeben sich in der Praxis oftmals zwangsläufig. Bei internen betrieblichen Versuchen der Anmelderin hat sich herausgestellt, dass die Anordnung eines piezokeramischen Bauteils "mit Luft" in einem (möglichst großen) Aktorraumvolumen die Lebensdauer des Bauteils in der Praxis tendenziell verlängern kann.

Die Isolierscheibe kann ferner weitere Kavitäten schaffende Aussparungen aufweisen. Solche Aussparungen können auch zur Förderung eines Gasaustausches zwischen den axial einander entgegengesetzten Seiten der Isolierscheibe geeignet vorgesehen werden. Wenn zusätzlich über oder unter der Isolierscheibe Kavitäten vorhanden sind oder bereitgestellt werden, so schaffen durch die Isolierscheibe hindurchgehende Aussparungen einen größeren zusammenhängenden Kavitätsraum, der sich vorteilhaft auf die Haltbarkeit des Piezoaktors auswirkt. Die Isolierscheibe lässt sich besonders wirtschaftlich z. B. aus Kunststoff als Spritzgussteil herstellen und kann mittels in die Öffnungen der Kopfanordnung ragender Hülsenfortsätze gleichzeitig im Bereich der Kopfanordnung isolieren. Mit einer solchen Isolierscheibe ergibt sich eine vergrößerte Freiheit bei der Wahl der Materials für die Abdichteinheit, da der elektrische Strom gezwungen wird, einen "Umweg", je nach geometrischer Gestaltung der Isolierscheibe, zu nehmen.

In einer bevorzugten Ausführungsform ist eine wie oben bereits erwähnte Kontaktbaugruppe mit einer Öffnung oder Aussparung vorgesehen, durch welche hindurch bzw. hinein sich ein axial abstehender, das aus mikroporösem Material gebildete Gasaustauschteil aufweisender Abschnitt des Trägers erstreckt. Damit kann die Möglichkeit zum schwerkraftbedingten Abfließen von Flüssigkeit von dem Gasaustauschteil, insbesondere aus dem Stellantriebgehäuse heraus, in besonders wirksamer und einfacher Weise sichergestellt werden. Bevorzugt ist hierbei, dass das Gasaustauschteil am oberen Ende eines nach oben hin abstehenden Trägerabschnitts angeordnet ist. In diesem Zusammenhang ist zu bemerken, dass die typische Einbaulage eines Stellantriebs bzw. des damit gebildeten Kraftstoffinjektors derart vorgesehen ist, dass die Axialrichtung des Stellantriebs eine Vertikalkomponente aufweist.

In einer Weiterbildung ist vorgesehen, dass das Stellantriebgehäuse einen den axial (z. B. durch die Öffnung der Kontaktbaugruppe hindurch) abstehenden Trägerabschnitt umgreifenden, insbesondere glockenartig umgreifenden Stellantriebgehäuseabschnitt aufweist. Eine solche "Gehäuseglocke" kann beispielsweise durch eine diesen Trägerabschnitt in Umfangsrichtung mit kleinem radialen Spalt umschließende Wandung realisiert werden. Damit wird z. B. vermieden, dass über die Gasaustauschpassage des Stellantriebgehäuses eingedrungene Flüssigkeit (z. B. Motoröl) im Schwall bis zum mikroporösen Gasaustauschteil aufsteigen kann. Der glockenartige Stellantriebgehäuseabschnitt sollte hierbei (mit geringem Spiel) oben geschlossen sein, so dass vorteilhaft das "Taucherglocken-Prinzip" zum Tragen kommt: Ein etwaiges Aufsteigen der Flüssigkeit in den Innenraum der Glocke komprimiert das darin befindliche Luftvolumen, so dass einem weiteren Aufsteigen der Flüssigkeit durch den Aufbau eines (wenn auch unter Umständen geringen) Gegendrucks entgegengewirkt wird. Auch bei einer geneigten Einbaulage des Stellantriebs im Bereich einer Brennkraftmaschine ist dieses Prinzip noch wirksam, solange der Neigungswinkel gegenüber der Vertikalrichtung eine bestimmte Größe nicht überschreitet, die von der Geometrie (z. B. Länge) des glockenartigen Gehäuseabschnitts abhängt.

Die Verbindung zwischen dem mikroporösen Material und dem Trägermaterial sollte möglichst innig (dicht) sein. In einer bevorzugten Ausführungsform ist das aus dem mikroporösen Material gebildete Gesamtaustauschteil daher mit dem Träger verschweißt.

Eine solche Verschweißung eignet sich z. B. zur Integration eines aus ePTFE (expandiertes Polytetrafluorethylen) gebildeten Gasaustauschteils. Dieses Material hat sich als sehr vorteilhaft herausgestellt, um damit "schädliche Medien" wie Kraftstoff (Diesel, Benzin, etc.) oder Schmierstoffe (z. B. Motoröl) am Eindringen in den Aktorraum zu hindern und gleichzeitig flüchtige Stoffe aus dem Aktorraum heraus und Luft bzw. Sauerstoff in den Aktorraum hinein diffundieren zu lassen. Andere hier verwendbare mikroporöse Materialien sind dem Fachmann wohlbekannt und bedürfen daher keiner weiteren Erläuterung.

Für einen einfachen Aufbau der Abdichtungsanordnung ist es von Vorteil, wenn das Gasaustauschteil im Wesentlichen scheibenförmig ist, beispielsweise ausgebildet als Membran. Eine derartige Gasaustauschscheibe kann sich z. B. über den gesamten Querschnitt einer Durchgangsöffnung der Abdichteinheit erstrecken und am Umfang mit dem angrenzenden Material (z. B. Trägermaterial) verschweißt sein (z. B. mittels Ultraschallverschweißung, Laserverschweißung, etc.). Alternativ kann die Scheibe auch durch eine ringsherum abdichtende Presspassung in eine solche Durchgangsöffnung eingefügt sein.

Die Erfindung wird nachfolgend anhand von Ausführungsbeispielen mit Bezug auf die beigefügten Zeichnungen näher beschrieben. Es stellen dar:
- Fig. 1: eine Schnittansicht eines oberen Endbereiches eines Stellantriebs für einen Kraftstoffinjektor,
- Fig. 2: eine schematische Ansicht eines mit dem Stellantrieb versehenen Kraftstoffinjektors,
- Fig. 3: eine Schnittansicht eines oberen Endbereiches eines Stellantriebs gemäß einer weiteren Ausführungsform, und
- Fig. 4: eine Schnittansicht eines oberen Endbereiches eines Stellantriebs gemäß einer weiteren Ausführungsform.

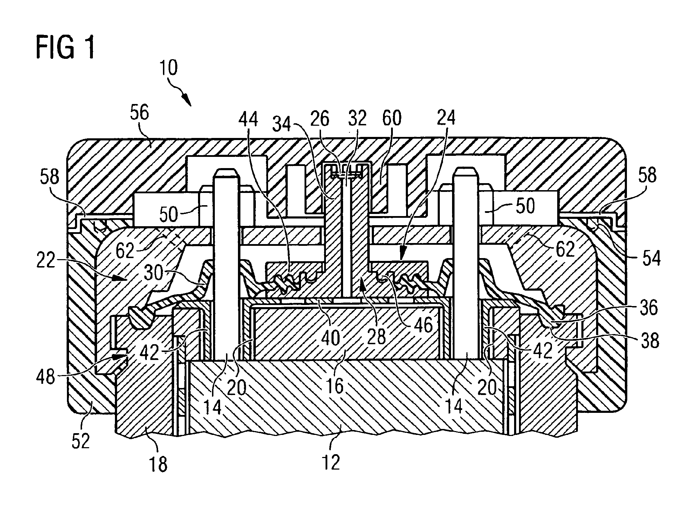

Fig. 1 zeigt eine Abdichtungsanordnung 10 zur Abdichtung eines aus einem Piezoelementstapel gebildeten, in einer Axialrichtung A langgestreckten Piezoaktors 12, der als Antriebskomponente eines Stellantriebs für einen Kraftstoffinjektor einer Brennkraftmaschine dient.

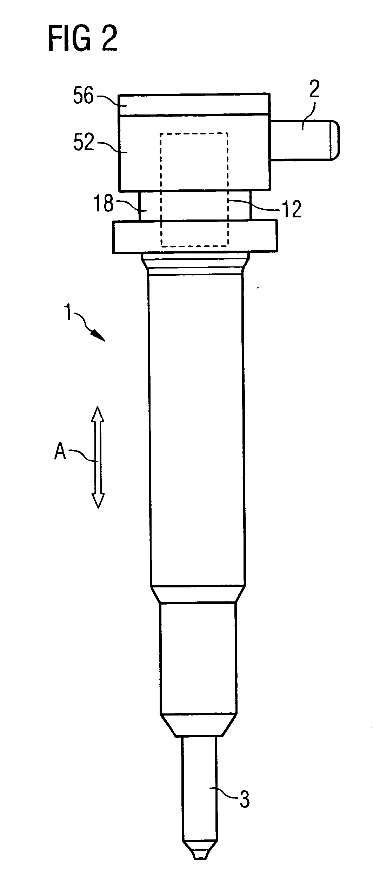

Fig. 2 veranschaulicht die Installationsumgebung des Piezoaktors 12 in dem Kraftstoffinjektor 1, der an seinem oberen Ende einen Steckverbinder 2 aufweist, dessen Kontakte über eine in einer Gehäuseanordnung 52, 56 untergebrachten Kontaktbaugruppe elektrisch mit den Enden von Anschlussstiften 14 (vgl. Fig. 1) des Piezoaktors 12 verbunden sind.

Über eine Wirkverbindung am unteren Ende des Piezoaktors 12 wird ein im unteren Bereich des Injektors 1 angeordnetes Kraftstoffeinspritzventil (z. B. hydraulisches Servoventil) angesteuert, um Kraftstoff über eine Einspritzdüse 3 in eine Brennkammer der Brennkraftmaschine einzuspritzen.

In Fig. 1 sind die aus dem Piezoaktor 12 hervorstehenden Anschlussstifte 14 und eine auf den Piezoaktor 12 aufgesetzte Kopfanordnung 16, 18 ersichtlich, die im dargestellten Beispiel aus einer Kopfplatte 16 und dem oberen Ende eines hülsenförmigen Aktorgehäuses 18 besteht und mit Bohrungen 20 zum Durchtritt der Anschlussstifte 14 versehen ist.

Insbesondere für einen vollständig in einem Zylinderkopf einer Brennkraftmaschine integrierten Dieselinjektor eines Common-Rail-Systems muss eine Abdichtung des Piezoaktors 12 vorgesehen werden, die den Aktorraum über die Anschlussstiftkontaktierung (zu der elektrischen Außenverbindung hin) gegen ein Eindringen von Flüssigkeiten zuverlässig abdichtet. Ansonsten besteht die Gefahr, dass über eine die elektrische Weiterverbindung von den Anschlussstiften 14 zu der Außenkontaktierung vorsehende Kontaktbaugruppe 22 "schädliche Medien" wie Motoröl, kraftstoffverdünntes Motoröl und Wasser in den Aktorraum eindringen können. Es hat sich jedoch herausgestellt, dass eine möglichst große Gaspermeation von "flüchtigen Stoffen" aus dem Aktorraum heraus und Luft bzw. Sauerstoff in den Aktorraum hinein die Haltbarkeit bzw. Lebensdauer des im Aktorraum befindlichen Piezoaktors 12 tendenziell verlängern kann.

Die geforderte gute Flüssigkeitsabdichtung bei gleichzeitiger Schaffung einer Gaspermeabilität ist bei der dargestellten Abdichtungsanordnung 10 durch Montage (Zwischenfügung) einer Abdichteinheit 24 zwischen der Kopfanordnung 16, 18 und der Kontaktbaugruppe 22 realisiert.

Die mehrteilige, als Montagekomponente vormontierte Abdichteinheit 24 umfasst im Wesentlichen drei im installierten Zustand der Abdichteinheit innig miteinander verbundene Werkstoffe bzw. Abdichteinheitskomponenten, nämlich eine mikroporöse Membran 26 aus ePTFE, einen Träger 28 aus Kunststoff, an welchem die mikroporöse Membran 26 umlaufend verschweißt ist, sowie eine (im dargestellten Beispiel einteilige) Dichtung 30 aus einem Elastomer. Mit diesem Dichtungsmaterial 30, mit welchem die Abdichteinheit 24 einerseits an Umfangsflächen der Anschlussstifte 14 und andererseits an einem stirnseitigen Umfangsbereich der Kopfanordnung 16, 18 flüssigkeitsdichtend anliegt, wird eine zuverlässige Abdichtung gegenüber einem Eindringen von schädlichen Medien aus der Umgebung des Kraftstoffinjektors in den Aktorraum unterhalb der Kopfplatte 16 vermieden.

Im dargestellten Beispiel ist das als Umspritzung des hülsenförmigen Trägers 28 ausgebildete Dichtmaterial 30 wie auch der Träger 28 selbst im Zentrum mit einer axial durchgehenden Gasaustauschöffnung 32 versehen, in deren Verlauf die ringsherum mit der Innenwandung eines axial nach oben emporragenden Abschnitts 34 des Trägers 28 verschweißte gasdurchlässige ePTFE-Membran 26 angeordnet ist.

Mit der Abdichteinheit 24 ist somit eine während der Montage des Kraftstoffinjektors einfach handzuhabende Baueinheit geschaffen, mittels welcher eine große Permeation bzw. Diffusion von gasförmigen Medien gestattet wird und gleichzeitig ein Eindringen von flüssigen Medien in den Aktorraum unterbunden wird.

Der Träger 28 besitzt die Hauptaufgabe, eine "Schnittstelle" zwischen dem Dichtmaterial 30 und dem Gasaustauschteil 26 bereitzustellen und die Abdichteinheit 24 mechanisch zu stabilisieren. Dies insbesondere im Hinblick auf die mikroporöse Membran 26, die als Filterelement sehr empfindlich gegenüber mechanischer Beschädigung ist. Da der Träger 28 nicht wesentlich für die zu bezweckende Abdichtungswirkung ist, kann dessen Material vergleichsweise frei gewählt werden. Im dargestellten Beispiel ist eine wesentliche Materialanforderung lediglich die Verschweißbarkeit mit dem Werkstoff der Membran 26 sowie eine gute Abdichtwirkung an den Grenzflächen zwischen dem Trägermaterial und dem Dichtmaterial 30.

Zur weiteren Stabilisierung und zum Schutz der Membran 26 kann abweichend vom dargestellten Ausführungsbeispiel noch ein Schutzdeckel über der Membran 26 vorgesehen sein, der z. B. durch eine Verschweißung (z. B. Ultraschallverschweißung) fest mit dem oberen Ende des Trägerabschnitts 34 verbunden wird. Damit der Deckel den über die Membran 26 stattfindenden Gasaustausch möglichst wenig behindert, kann ein solcher Deckel als "Schutzgitter" ausgebildet sein. Ein solcher Deckel schützt die Membran 26 auch gut für den Fall, dass die Abdichteinheit 24 im Rahmen einer automatisierten Fertigung des Kraftstoffinjektors eingebracht wird.

Das Material der Dichtung 30 liegt mit elastischer Vorspannung an den Umfangsflächen der Anschlussstifte 14 an. Dies ist dadurch realisiert, dass die Dichtung 30 mit Öffnungen zum Durchtritt der Anschlussstifte 14 gebildet ist und jede Öffnungsquerschnittsfläche im entspannten Zustand der Dichtung 30 kleiner als die Querschnittsfläche des betreffenden Anschlussstiftabschnitts im Bereich der Radialabdichtung ist.

Die zuverlässige Axialabdichtung erfolgt im dargestellten Ausführungsbeispiel dadurch, dass ein ringförmiger, nach unten abstehender Vorsprung ("Dichtlippe") 36 in eine korrespondierende Ringnut 38 des Aktorgehäuses 18 gepresst wird. Diese Verpressung im Bereich der Axialabdichtung wird durch Ausübung axialen Drucks von einem Kunststoffkorpus der Kontaktbaugruppe 22 vorgesehen. Die Kontaktbaugruppe 22 presst die Dichtung 30 an ihrem Außenumfang axial gegen das Aktorgehäuse 18, so dass die belasteten Dichtungsabschnitte zwischen der Kontaktbaugruppe 22 und dem Aktorgehäuse 18 eingeklemmt werden.

Das für die Dichtung 30 verwendete Material (hier: Elastomer) ist elektrisch isolierend. Durch diese Materialwahl sind keine besonderen Vorkehrungen gegen eine unzureichende elektrische Isolierung der Anschlussstifte 14 in dem Fall zu treffen, in welchem die Kopfanordnung 16, 18 elektrisch leitet. Letzteres ist in der Regel der Fall, da diese üblicherweise aus metallischen Werkstoffen hergestellt wird. Für den Fall, dass bei einer elektrisch leitenden Kopfanordnung 16, 18 das Material der Dichtung 30 bzw. das Trägermaterial 28 nicht ausreichend elektrisch isoliert, kann - wie dargestellt - vorgesehen sein, dass zumindest in den Bereichen der Anlage der Abdichteinheit 24, insbesondere der Dichtung 30, an der Kopfanordnung 16, 18 die Kopfanordnung elektrisch isoliert ist, z. B. mit einer Isolationsschicht bzw. einem Isolationsteil versehen ist. Diese Isolationsschicht ist hier als eine Isolierscheibe 40 ausgebildet, die sich bis nahe zum Umfangsbereich der Kopfanordnung 16, 18 erstreckt und ebenfalls Öffnungen zum Durchtritt der Anschlussstifte 14 sowie weitere Öffnungen ("perforierte Isolierscheibe") aufweist. Die Isolierscheibe 40 ist vorteilhaft mit nach unten abstehenden Hülsenfortsätzen 42 versehen (einteilig angeformt), die sich in die Bohrungen 20 der Kopfplatte 16 hinein erstrecken, um die Anschlussstifte 14 dort gegenüber der Innenwandung dieser Bohrungen 20 zu isolieren und zu zentrieren.

Bei dem dargestellten Ausführungsbeispiel der Abdichteinheit 24 ist die innige Verbindung zwischen dem Material der Dichtung 30 und dem Träger 28 durch eine axiale Verpressung gesichert. Zu diesem Zweck ist ein Pressring 44 aus Kunststoff vorgesehen, dessen Innenumfang durch eine Ultraschallverschweißung 46 fest mit einem Fußbereich des Trägers 28 verbunden ist und der den Innenumfang der Dichtung 30 axial gegen diesen Fußbereich des Trägers 28 presst. Diese auf Grund der Elastizität des eingeklemmten Materials (Elastomer) dauerhafte Verpressung gewährleistet die Dichtigkeit der Verbindung zwischen dem Träger 28 und der Dichtung 30. Zur Herstellung der Abdichteinheit 24 kann beispielsweise der Träger 28 als Einlegeteil in einem Umspritzungsprozess verwendet werden, bei welchem das dichtende Material 30 als eine Umspritzung gebildet wird. Die damit erreichte Verbindung zwischen dem Träger 28 und der Dichtung 30 wird durch das nachträgliche Aufsetzen und Verschweißen des Pressrings 44 gesichert. Zur Erhöhung der Abdichtungswirkung verlaufen die Grenzflächen zwischen der Dichtung 30 einerseits und dem Fußbereich des Trägers 28 bzw. dem Pressring 44 andererseits jeweils korrugiert.

Abweichend vom dargestellten Ausführungsbeispiel könnte der Fußbereich des Trägers 28 sich radial weiter nach außen bis über die Radialpositionen der Anschlussstifte 14 hinaus erstrecken und im Bereich dieser Anschlussstifte Öffnungen zum Durchtritt derselben aufweisen. Damit kann beispielsweise die Abdichteinheit 24 insgesamt weiter mechanisch stabilisiert werden. Ferner vergrößert sich vorteilhaft die Grenzfläche zwischen dem Dichtmaterial 30 und dem Träger 28, was zur Verbesserung der Abdichtung an dieser Grenzfläche nutzbar ist. Schließlich kann mit einer solchen "voluminöseren" Gestaltung des Trägers 28 auch eine einteilige Ausbildung dieses Trägers 28 mit nach unten in die Bohrungen 20 der Kopfplatte 16 ragenden Hülsenfortsätzen realisiert werden, die bei der dargestellten Ausführungsform als Fortsätze der separat vom Träger 28 vorgesehenen Isolierscheibe 40 vorgesehen sind. Die Gestaltung eines radial weit ausladenden Trägers 28 mit den Hülsenfortsätzen kombiniert dann gewissermaßen den Träger 28 und die dargestellte Isolierscheibe 40 miteinander.

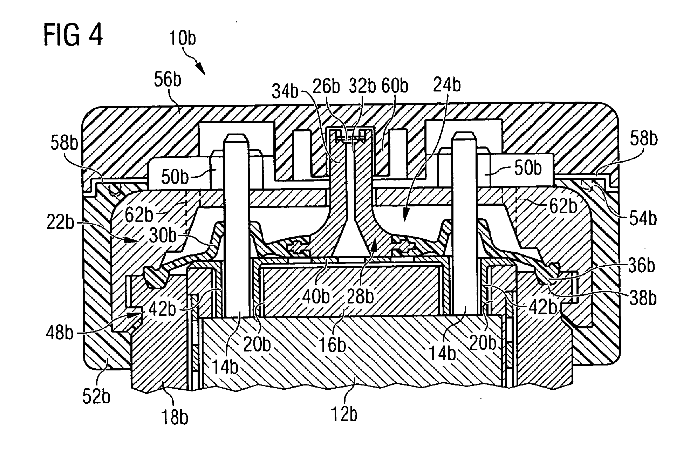

Zur Schaffung einer innigen Verbindung zwischen dem Träger 28 und der Dichtung 30 ist es ferner denkbar, das dichtende Material als eine Komponente in einem Zwei-Komponenten-Spritzgussverfahren zusammen mit dem Träger 28 herzustellen oder zwischen diesen Materialien eine innige Verbindung durch Vulkanisation zu schaffen (vgl. z. B. Fig. 4). In diesen Fällen kann unter Umständen auf eine nachträgliche Verpressung der Dichtung 30 verzichtet werden.

Ebenfalls abweichend vom dargestellten Ausführungsbeispiel könnte auf die Verschweißung des Pressrings 44 bzw. auf den Pressring 44 als solchen auch verzichtet werden, wenn der Pressring 44 bzw. der einzuklemmende ringförmige Abschnitt der Dichtung 30 axial durch einen Materialabschnitt der Kontaktbaugruppe 22 belastet wird. Die dargestellte Ausführungsform könnte beispielsweise derart modifiziert werden, dass der Kunststoffkorpus der Kontaktbaugruppe 22 nicht nur axial den Außenumfang der Dichtung 30 belastet sondern auch unmittelbar oder mittelbar (über einen zunächst lose eingelegten Pressring) den Innenumfang dieser Dichtung 30 belastet, etwa durch einen axial nach unten abstehenden ringförmigen Vorsprung der Kontaktbaugruppe 22 in diesem Bereich.

Bei der Montage des Stellantriebs wird die vorgefertigte Abdichteinheit 24 an den aus den Bohrungen 20 hervorstehenden Abschnitten der Anschlussstifte 14 aufgesetzt. Sodann wird durch Aufdrücken der Kontaktbaugruppe 22 die Verpressung zur Axialabdichtung bewerkstelligt. Nach dem Aufdrücken der Kontaktbaugruppe 22 wird dieselbe durch eine im Umfangsbereich vorgesehene Rastverbindung 48 gehalten. Dies kann z. B. wie bei dem dargestellten Ausführungsbeispiel mit umlaufender Verrastung oder alternativ durch einzelne Rasten über den Umfang verteilt vorgesehen sein. Dann erfolgt eine Verschweißung der Anschlussstiftenden an hierfür vorgesehenen metallischen Schweißlaschen 50 der Kontaktbaugruppe 22. Vor oder nach dieser Verschweißung erfolgt eine finale Ummantelung des oberen Endes des Stellantriebs.

Die finale Ummantelung ist im dargestellten Beispiel zweiteilig ausgeführt, nämlich von einer Kunststoffumspritzung 52 sowie einem darauf aufgesetzten und bei 54 ultraschallverschweißten Gehäusedeckel 56.

Durch die Kunststoffumspritzung 52 wird die Rastverbindung 48 zwischen dem Aktorgehäuse 18 und der Kontaktbaugruppe 22 vorteilhaft gesichert und unter Umständen sogar die axiale Verpressung der Dichtung 30 verstärkt (durch Schwinden des Umspritzungsmaterials beim Abkühlen).

Diese zweiteilige Ausführung des oberen Bereichs des Stellantriebgehäuses besitzt den besonderen Vorteil, dass damit in einfacher Weise eine oder mehrere Gasaustauschöffnungen 58 des Stellantriebgehäuses 52, 56 vorgesehen werden können, die als Teil der durch dieses Stellantriebgehäuses hindurch verlaufenden Gasaustauschpassage fungieren. Jede solche Gasaustauschöffnung 58 kann z. B. als Spalt zwischen diesen Bauteilen vorgesehen sein. In einfacher Weise kann die Gasaustauschöffnung 58 z. B. labyrinthartig als Spalt zwischen diesem Umhüllungskomponenten ausgebildet werden, wie in Fig. 1 dargestellt.

Eine labyrinthartige Gestaltung der äußeren Belüftungsöffnung 58 verhindert ein Eindringen von festen Gegenständen in den Innenraum dieser Umhüllung 52, 56. Außerdem ermöglicht der in Fig. 1 ersichtliche Verlauf dieser Öffnung 58, dass eine etwaig in den Innenraum der Umhüllung 52, 56 eingedrungene Flüssigkeit wie Motoröl schwerkraftbedingt von selbst wieder herausfließen kann. Hierfür sollte ein unterer Rand der Öffnung 58 (wie auch der vorausgehenden Passage) an keiner Stelle im Verlauf nach außen hin ansteigen, insbesondere stets abfallen.

Abweichend vom dargestellten Ausführungsbeispiel ist es prinzipiell denkbar, eine wie bei herkömmlichen Kraftstoffinjektoren übliche einteilige Kunststoffumspritzung vorzusehen, die jedoch zur Schaffung wenigstens einer Gasaustauschöffnung nachträglich perforiert (z. B. durchbohrt) wird. Für eine labyrinthartige Gestaltung der Gasaustauschöffnung eignet sich jedoch besser eine mehrteilige Ausführung, wie z. B. in Fig. 1 dargestellt.

Das aus mikroporösem Material gebildete Gasaustauschteil in Form der ePTFE-Membran 26 ist "erhöht" angeordnet (am oberen Ende des emporragenden Trägerabschnitts 34). Damit ist die Membran 26 vor einer permanenten Benetzung mit eingedrungener Flüssigkeit geschützt. Etwaig, z. B. durch die Gasaustauschöffnungen 58 hindurch, auf die Innenseite des Stellantriebgehäuses 52, 56 eingedrungene Flüssigkeit läuft zwar schwerkraftbedingt durch diese Gasaustauschöffnungen 58 wieder heraus. Dies jedoch nur bis zu einem bestimmten Niveau, welches im Wesentlichen durch die Lage der Öffnungen 58 (und die konkrete Einbaulage des Stellantriebs) bestimmt wird. Wie aus Fig. 1 ersichtlich ergibt sich jedoch eine erhebliche Höhendifferenz zwischen diesem Flüssigkeitsniveau und der Außenseite (obere Oberfläche) der Membran 26. Diese Höhendifferenz führt dazu, dass eine die Membran 26 benetzende Flüssigkeit von der Membran abfließt, die im dargestellten Ausführungsbeispiel in einem Aufnahmeabschnitt des oberen Endes des emporragenden Trägerabschnitts 34 angeordnet ist, der eine zinnenartige seitliche Umrandung aufweist. Diese "Zinnenkonstruktion" behindert nicht das Abfließen von Flüssigkeit von der Membran 26 und schützt die Membran bei der Montage des Stellantriebs. Alternativ könnte die Membran 26 (ohne einen solchen Schutz) unmittelbar an einer ebenen (horizonatelen oder geneigten) Endfläche des emporragenden Trägerabschnitts 34 aufgebracht (z. B. verschweißt) sein.

Der Gehäusedeckel 56 weist eine das obere Ende des emporragenden Trägerabschnitts 34 umlaufend umgebende Wandung 60 auf, so dass ein etwaig in das Gehäuse eindringender Flüssigkeitsschwall nicht ohne weiteres die Membran 26 erreichen kann. Darüber hinaus wirkt diese umlaufende Wandung 60 nach Art einer "Taucherglocke" derart, dass eine durch den (vergleichsweise schmalen) Spalt zwischen dem Trägerabschnitt 34 und der Wandung 60 aufsteigende Flüssigkeit an einem weiteren Aufstieg bis auf die Höhe der Membran 26 gehindert wird durch Aufbau eines Gegendrucks durch das dann in der Glocke eingeschlossene und komprimierte Luftvolumen. Zu bedenken ist hierbei, dass das hierfür maßgebliche Luftvolumen im Wesentlichen nur durch das über und neben dem emporragenden Trägerabschnitt 34 befindliche Volumen bestimmt wird, da die Membran 26 einen erheblichen Strömungswiderstand besitzt.

Wie aus Fig. 1 weiter ersichtlich, erstreckt sich die glockenartige Wandung 60 axial nach unten nur bis zu einer Höhe, die über dem Niveau einer etwaig im Gehäuse verbleibenden Flüssigkeit (definiert durch die Lage der Öffnungen 58) liegt. Dies besitzt z. B. den besonderen Vorteil, dass Fluidreste in der Glocke beim Ablaufen der Flüssigkeit vermieden werden, die ansonsten bei Aufbau eines Unterdrucks im Aktorraum über die Membran 26 angesaugt werden könnten. Ein solcher Unterdruck kann z. B. bei Abkühlung der Brennkraftmaschine und somit des im Aktorraum eingeschlossenen Luftvolumens entstehen.

Bei der dargestellten Ausführungsform ist es nicht ausgeschlossen, dass eine über die Gasaustauschöffnungen 58 eingedrungene Flüssigkeit über die zum Durchtritt der Anschlussstifte 14 sowie des emporragenden Trägerabschnitts 34 vorgesehenen Öffnungen der Kontaktbaugruppe 20 weiter in den Raum zwischen der Kontaktbaugruppe 20 und der Abdichteinheit 24 läuft. Dies ist jedoch unschädlich, da in diesem Bereich die Abdichteinheit 24 ein weiteres Vordringen der Flüssigkeit in Richtung zum Aktorraum hin verhindert. Falls gewünscht, können jedoch auch Ablaufpassagen zum Abführen der Flüssigkeit aus diesem Bereich vorgesehen sein. Bei geneigter Einbaulage des Stellantriebs können beispielsweise in Fig. 1 gestrichelt eingezeichneten zusätzlichen Ablaufbohrungen 62 einen solchen Ablauf fördern.

Bei der nachfolgenden Beschreibung von weiteren Ausführungsbeispielen werden für analoge Komponenten die gleichen Bezugszahlen verwendet, jeweils ergänzt durch einen kleinen Buchstaben zur Unterscheidung der Ausführungsform. Dabei wird im Wesentlichen nur auf die Unterschiede zu dem bzw. den bereits beschriebenen Ausführungsbeispielen eingegangen und im Übrigen hiermit ausdrücklich auf die Beschreibung vorangegangener Ausführungsbeispiele verwiesen.

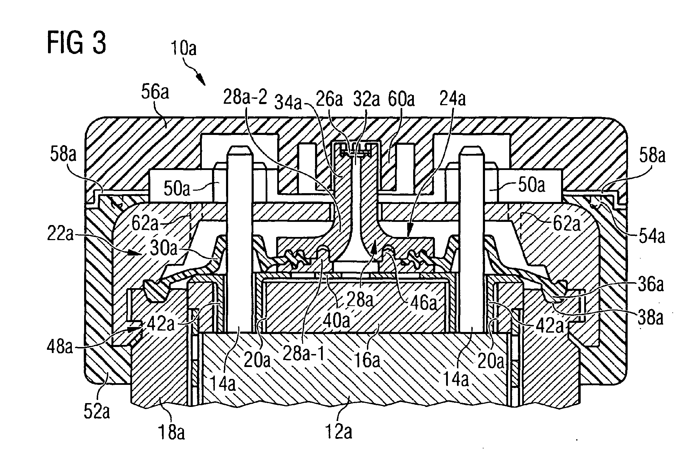

Fig. 3 zeigt den oberen Endbereich eines Stellantriebs gemäß einer weiteren Ausführungsform. Im Unterschied zu der mit Bezug auf Fig. 1 beschriebenen Ausführungsform ist ein Träger 28a aus zwei Kunststoffteilen 28a-1 und 28a-2 gebildet, die mittels einer Ultraschallverschweißung 46a unlösbar miteinander verbunden sind. Axial zwischen diesen Teilen 28a-1 und 28a-2 ist wieder ein Innenumfangsrand einer Dichtung 30a eingeklemmt. Die Teile 28a-1 und 28a-2 sowie die Dichtung 30a wurden bei dieser Ausführungsform zunächst separat hergestellt und miteinander verbunden. Bereits vorher oder danach wurde eine mikroporöse Membran 26a am oberen Ende des aufragenden Trägerteils 28a-2 angebracht. Ein Stellantriebgehäuse 52a, 56a ist mit mehreren (z. B. etwa 3 bis 6) über den Umfang verteilt angeordneten Gasaustauschöffnungen 58a versehen. Damit ist sichergestellt, dass auch bei einer vergleichsweise stark (gegenüber der Vertikalen) geneigten Einbaulage des Stellantriebs wenigstens eine der Öffnungen 58a im Betrieb gut als Abflussöffnung für eingedrungene Flüssigkeiten wirken kann. Eine oder mehrere in Einbaulage demgegenüber erhöht angeordnete Öffnungen 58a können dann als "Luftnachfuhröffnungen" wirken und somit das Abfließen der Flüssigkeit fördern. Alternativ könnte auch eine sich um den ganzen Umfang herum erstreckende Gasaustauschöffnung 58a vorgesehen sein.

Fig. 4 zeigt schließlich eine weitere Ausführungsform, bei welcher auf eine nachträgliche Verpressung einer Dichtung 30b verzichtet ist. Eine innige Verbindung zwischen der Dichtung 30b und einem Träger 28b ist bei dieser Ausführungsform vielmehr durch eine Vulkanisation der aneinander angrenzenden Materialien 28b, 30b geschaffen (die z. B. in einem Zwei-Komponenten-Spritzgussverfahren hergestellt wurden). Zur Vergrößerung der Grenzfläche und somit der durch Vulkanisation geschaffenen Dichtwirkung ist der Außenumfangsbereich des Trägers 28b wieder profiliert gestaltet.

Zusammenfassend wird ein Abdichtkonzept für einen Piezoaktor mit integriertem Gasaustauschteil bereitgestellt, welches insbesondere zur Verwendung in motorölhaltiger Umgebung einsetzbar ist. Das Gasaustauschteil wird über einen Träger mit einem Dichtmaterial verbunden. Eine dauerhafte Benetzung des Gasaustauschteils kann durch entsprechende geometrische Anordnung desselben (z. B. relativ weit oben, mit Ablussmöglichkeiten) vermieden werden.

## Patentansprüche

1. Stellantrieb für einen Kraftstoffinjektor (1) einer Brennkraftmaschine, umfassend einen Piezoaktor (12) mit aus dem Piezoaktor hervorstehenden Anschlussstiften (14) und einer auf den Piezoaktor aufgesetzten Kopfanordnung (16, 18), die mit Öffnungen (20) zum Durchtritt der Anschlussstifte (14) versehen ist, **dadurch gekennzeichnet, dass** wenigstens eine durch ein Stellantriebgehäuse (52, 54) hindurch verlaufende Gasaustauschpassage vorgesehen ist, über welche ein Gasaustausch zwischen der Außenseite und der Innenseite des Stellantriebgehäuses (52, 54) ermöglicht wird, und dass eine auf die Kopfanordnung (16, 18) aufgesetzte und mit Öffnungen zum Durchtritt der Anschlussstifte (14) versehene Abdichteinheit (24) zur Abdichtung des Piezoaktors (12) vorgesehen ist, die einen Träger (28) aufweist, an welchem ein dichtendes Material (30) angeordnet ist, das an Umfangsflächen der Anschlussstifte (14) und an einem Umfangsbereich (18) der Kopfanordnung (16, 18) dichtend anliegt, und an welchem ein aus mikroporösem Material gebildetes Gasaustauschteil (26) zur Schaffung einer Gaspermeabilität der Abdichteinheit (24) derart integriert ist, dass in Einbaulage des Stellantriebs eine etwaig zu dem Gasaustauschteil (26) vorgedrungene Flüssigkeit schwerkraftbedingt vom Gasaustauschteil (26) abfließen kann.

2. Stellantrieb nach Anspruch 1, wobei der Träger (28) aus Kunststoff gebildet ist.

3. Stellantrieb nach einem der vorangehenden Ansprüche, wobei das dichtende Material (30) ein Elastomer ist.

4. Stellantrieb nach einem der vorangehenden Ansprüche, wobei das dichtende Material (30) als eine Umspritzung des Trägers (28) ausgebildet ist.

5. Stellantrieb nach einem der vorangehenden Ansprüche, wobei das dichtende Material (30) als eine Komponente in einem Zwei-Komponenten-Spritzgussverfahren hergestellt ist.

6. Stellantrieb nach einem der vorangehenden Ansprüche, wobei zwischen dem Material des Trägers (28) und dem dichtenden Material (30) eine innige Verbindung durch eine Vulkanisation geschaffen ist.

7. Stellantrieb nach einem der vorangehenden Ansprüche, wobei das dichtende Material (30) zum Träger (28) hin verpresst ist.

8. Stellantrieb nach einem der vorangehenden Ansprüche, wobei das aus dem mikroporösen Material gebildete Gasaustauschteil (26) mit dem Träger (28) verschweißt ist.

9. Stellantrieb nach einem der vorangehenden Ansprüche, wobei das mikroporöse Material von ePTFE gebildet ist.

10. Stellantrieb nach einem der vorangehenden Ansprüche, wobei das aus dem mikroporösen Material gebildete Gasaustauschteil (26) im Wesentlichen scheibenförmig ist.

11. Stellantrieb nach einem der vorangehenden Ansprüche, umfassend eine an der Abdichteinheit (24) aufgesetze Kontaktbaugruppe (22) zur elektrischen Weiterverbindung der Anschlussstifte (14).

12. Stellantrieb nach Anspruch 11, wobei die Kontaktbaugruppe (22) die Abdichteinheit (24) wenigstens abschnittsweise gegen die Kopfanordnung (16, 18) presst.

13. Stellantrieb nach Anspruch 11 oder 12, wobei die Kontaktbaugruppe einen Umfangsbereich der Kopfanordnung (16, 18) umgreift und an diesem Umfangsbereich durch eine Rastverbindung (48) gehalten ist.

14. Stellantrieb nach einem der Ansprüche 11 bis 13, wobei die Kontaktbaugruppe (22) eine Öffnung aufweist, durch welche hindurch sich ein axial abstehender, das Gasaustauschteil (26) aufweisender Abschnitt (34) des Trägers (28) erstreckt.

15. Stellantrieb nach einem der vorangehenden Ansprüche, wobei das Stellantriebgehäuse (52, 54) einen Stellantriebgehäuseabschnitt (60) aufweist, welcher einen das Gasaustauschteil (26) aufweisenden Abschnitt (34) des Trägers (28) übergreift.

16. Stellantrieb nach einem der vorangehenden Ansprüche, wobei das Stellantriebgehäuse (52, 54) eine äußere Ummantelung aufweist, in welcher wenigstens eine labyrinthartige Gasaustauschöffnung (58) vorgesehen ist.

17. Stellantrieb nach Anspruch 16, wobei das Stellantriebgehäuse aus mehreren Bauteilen (52, 54) gebildet ist und die Gasaustauschöffnung (58) als Spalt zwischen diesen Bauteilen vorgesehen ist.

18. Verwendung eines Stellantriebs nach einem der Ansprüche 1 bis 17 innerhalb einer Motorblockbaugruppe einer Brennkraftmaschine.

## Claims

1. Actuator for a fuel injector (1) of an internal combustion engine, comprising a piezoactuator (12) with contact pins (14) projecting from the piezoactuator and a head arrangement (16, 18) placed on the piezoactuator, which is provided with openings (20) to allow the passage of contact pins (14), **characterized in that** at least one gas exchange passage passing through the actuator housing (52, 54) via which a gas exchange between the inside and the outside of the actuator housing (52, 54) is made possible, is provided and that a sealing unit (24) for sealing the piezoactuator (12) placed on the head arrangement (16, 18) and with openings to allow the passage of the contact pins (14) is provided, which features a carrier (28) on which a sealing material (30) is arranged which provides a seal around the contact pins (14) and the circumference (18) of the head arrangement (16, 18) and on which a gas exchanger made of microporous material (26) to create a gas permeability of the sealing unit (24) is integrated in such a way that, in the mounting position of the actuator, any fluid intruding into the gas exchanger (26) can flow out of the gas exchanger (26) through the effect of gravitational force.

2. Actuator in accordance with claim 1, where the carrier (28) is made of plastic.

3. Actuator in accordance with one of the previous claims, in which the sealing material (30) is an elastomer.

4. Actuator in accordance with one of the previous claims, in which the sealing material (30) is embodied as an injection moulding of the carrier (28).

5. Actuator according to one of the previous claims, in which the sealing material (30) is manufactured as a component in a two-component injection moulding process.

6. Actuator in accordance with one of the previous claims, in which, between the material of the carrier (28) and the sealing material (30), an internal connection is created through a vulcanisation.

7. Actuator in accordance with one of the previous claims, in which the sealing material (30) is pressed into the carrier (28).

8. Actuator in accordance with one of the previous claims, in which the gas exchanger (26) made of microporous material is welded to the carrier (28).

9. Actuator in accordance with one of the previous claims, in which the microporous material is made of ePTFE.

10. Actuator in accordance with on of the previous claims, in which the gas exchanger (26) made of microporous material (26) is essentially disk-shaped.

11. Actuator in accordance with one of the previous claims, comprising a contact module (22) placed on the sealing unit (24) for further electrical connection of the contact pins (14).

12. Actuator in accordance with claim 11, where the contact module (22) presses at least sections of the sealing unit (24) against the head arrangement (16, 18).

13. Actuator in accordance with claim 11 or 12, where the contact module grips a circumferential area of the head arrangement (16, 18) and is held on this circumferential area by a latching connection (48).

14. Actuator in accordance with one of the claims 11 to 13, where the contact module (22) features an opening through which an axially projecting section (34) of the carrier (28) featuring the gas exchanger (26) extends.

15. Actuator in accordance with one of the previous claims, in which the actuator housing (52, 54) features an actuator housing section (60) which engages with a section (34) of the carrier (28) featuring the gas exchanger (26).

16. Actuator in accordance with one of the previous claims, in which the actuator housing (52, 54) features an external surrounding section in which at least one labyrinth-type gas exchanger opening (58) is provided.

17. Actuator in accordance with claim 16, where the actuator housing is made up of several components (52, 54) and the gas exchanger opening (58) is provided as a gap between these components.

18. Use of an actuator in accordance with one of the claims 1 to 17 within an engine block group of an internal combustion engine.

## Revendications

1. Entraînement de commande pour un injecteur de carburant (1) d'un moteur à combustion interne, comprenant un actionneur piézoélectrique (12) possédant des broches de connexion (14) qui émergent de l'actionneur piézoélectrique, et un dispositif de tête (16, 18) monté sur l'actionneur piézoélectrique, qui est muni d'ouvertures (20) pour le passage des broches de connexion (14), **caractérisé en ce qu'**il est prévu au moins un passage d'échange gazeux qui s'étend à travers un boîtier (52, 54) de l'entraînement de commande et au moyen duquel un échange gazeux peut s'effectuer entre l'extérieur et l'intérieur du boîtier (52, 54) de l'entraînement de commande, et **en ce qu'**il est prévu une unité d'étanchéité (24) pour l'isolation de l'actionneur piézo-électrique (12), montée sur le dispositif de tête (16, 18) et munie d'ouvertures pour le passage des broches de connexion (14), et qui présente un support (28) contre lequel est appuyée une matière d'étanchéité (30) qui est en contact à joint étanche avec des surfaces périphériques des broches de connexion (14) et avec une région périphérique (18) du dispositif de tête (16, 18), et auquel est intégré un élément d'échange gazeux (26) formé d'une matière microporeuse et destiné à créer une perméabilité au gaz de l'unité d'étanchéité (24) de telle manière que, dans la position de montage de l'entraînement de commande, un liquide éventuellement refoulé vers l'élément d'échange gazeux (26) puisse s'écouler de l'élément d'échange gazeux par gravité.

2. Entraînement de commande selon la revendication 1, dans lequel le support (28) est fait de matière plastique.

3. Entraînement de commande selon une des revendications précédentes, dans lequel la matière d'étanchéité (30) est un élastomère.

4. Entraînement de commande selon une des revendications précédentes, dans lequel la matière d'étanchéité (30) est constituée par un enrobage du support (28).

5. Entraînement de commande selon une des revendications précédentes, dans lequel la matière d'étanchéité (30) est fabriquée sous la forme d'un composant selon un procédé de moulage par injection à deux composants.

6. Entraînement de commande selon une des revendications précédentes, dans lequel une liaison intime entre la matière du support (28) et la matière d'étanchéité (30) est créée par une vulcanisation.

7. Entraînement de commande selon une des revendications précédentes, dans lequel la matière d'étanchéité (30) est serrée sur le support (28).

8. Entraînement de commande selon une des revendications précédentes, dans lequel la partie d'échange gazeux (26) formée de la matière microporeuse est soudée au support (28).

9. Entraînement de commande selon une des revendications précédentes, dans lequel la matière microporeuse est faite de ePTFE.

10. Entraînement de commande selon une des revendications précédentes, dans lequel la partie d'échange gazeux (26) formée de la matière microporeuse est sensiblement en forme de disque.

11. Entraînement de commande selon une des revendications précédentes, comprenant un groupe de contact posé contre l'unité d'étanchéité (24) pour la prolongation électrique des broches de connexion (14).

12. Entraînement de commande selon la revendication 11, dans lequel le groupe de contact (22) serre l'unité d'étanchéité (24) contre le dispositif de tête (16, 18), du moins par endroits.

13. Entraînement de commande selon la revendication 11 ou 12, dans lequel le groupe de contact comprend une région périphérique du dispositif de tête (16, 18) et est retenu contre cette région périphérique par une liaison à encliquetage.

14. Entraînement de commande selon une des revendications 11 à 13, dans lequel le groupe de contact (22) présente une ouverture à travers laquelle passe une partie (34) du support (28) qui fait saillie axialement et qui présente la partie d'échange gazeux (26).

15. Entraînement de commande selon une des revendications précédentes, dans lequel le boîtier (52, 54) de l'entraînement de commande présente une partie de boîtier d'entraînement de commande (60) qui emboîte une partie (34) du support qui présente la partie d'échange gazeux (26).

16. Entraînement de commande selon une des revendications précédentes, dans lequel le boîtier (52, 54) de l'entraînement de commande présente un enveloppement extérieur dans lequel est prévue au moins une ouverture d'échange gazeux (58) en forme de labyrinthe.

17. Entraînement de commande selon la revendication 16, dans lequel le boîtier de l'entraînement de commande est fait de plusieurs éléments (52, 54) et l'ouverture d'échange gazeux (58) est prévue sous la forme d'une fente entre ces éléments.

18. Utilisation d'un entraînement de commande selon une des revendications 1 à 17 dans un groupe de bloc moteur d'un moteur à combustion interne.
